Europäisches Patentamt

European Patent Office

Office européen des brevets

(19)

(11) Numéro de publication: **0 128 061**
**B1**

(12) **FASCICULE DE BREVET EUROPEEN**

(45) Date de publication du fascicule du brevet: 20.07.88

(21) Numéro de dépôt: 84400901.9

(22) Date de dépôt: 03.05.84

(51) Int. Cl.⁴: **H 01 L 29/62,** H 01 L 21/318, H 01 L 29/38

(54) Transistor à effet de champ fonctionnant en mode de désertion profonde.

(30) Priorité: 10.05.83 FR 8307791

(43) Date de publication de la demande:
12.12.84 Bulletin 84/50

(45) Mention de la délivrance du brevet:
20.07.88 Bulletin 88/29

(84) Etats contractants désignés:
DE GB NL

(56) Documents cités:

THIN SOLID FILMS, vol. 85, no. 1, octobre 1981, pages 61-69, Elsevier Sequoia, Lausanne, NL; J. WOODWARD et al.: "The deposition of insulators onto InP using plasma-enhanced chemical vapour deposition"

JOURNAL OF THE ELECTROCHEMICAL SOCIETY, vol. 125, no. 5, mai 1978, pages 819-823, Princeton, US; D. DONG et al.: "Preparation and some properties of chemically vapor-deposited Si-rich SiO2 and Si3N4 films"

(73) Titulaire: THOMSON-CSF
173, Boulevard Haussmann
F-75379 Paris Cédex 08 (FR)

(72) Inventeur: Kohn, Erhard
THOMSON-CSF SCPI 173, bld Haussmann
F-75379 Paris Cedex 08 (FR)
Inventeur: Dortu, Jean-Marc
THOMSON-CSF SCPI 173, bld Haussmann
F-75379 Paris Cedex 08 (FR)

(74) Mandataire: Taboureau, James et al
THOMSON-CSF SCPI 19, avenue de Messine
F-75008 Paris (FR)

(56) References cited:
JOURNAL OF THE ELECTROCHEMICAL SOCIETY, vol. 117, no. 11, novembre 1970, pages 1410-1417, Princeton, US; J.E. FOSTER et al.: "Electrical characteristics of the silicon nitride-gallium arsenide interface"

Courier Press, Leamington Spa, England.

**0 128 061**

(58) References cited:
JOURNAL OF THE ELECTROCHEMICAL
SOCIETY, vol. 130, no. 3, mars 1983, page 78C,
abrégé no. 109, Manchester, New Hampshire,
US; D.C. LIU et al.: "Plasma deposited nitride
films on GaAs and InP"

JOURNAL OF THE ELECTROCHEMICAL
SOCIETY, vol. 128, no. 7, juillet 1981, pages
1555-1563, Princeton, US; H. DUN et al.:
"Mechanisms of plasma-enhanced silicon
nitride deposition using SiH4/N2 mixture"

## Description

La présente invention concerne un transistor à effet de champ à haute fréquence de fonctionnement, doté d'une couche diélectrique présentant une fuite entre la métallisation de grille et la couche active du transistor. Le transistor selon l'invention a des performances qui sont intermédiaires entre celles d'un transistor à effet de champ de type métal/semiconducteur et un transistor à effet de champ de type métal/isolant/semiconducteur. La nature de la couche diélectrique présentant une fuite placée entre la métallisation de grille du transistor et la couche active tient essentiellement à ce que cette couche est réalisée en nitrure de silicium riche en silicium dans des proportions non stoechiométriques, l'effet de fuite obtenu grâce à ces proportions étant, dans une variante de l'invention, modifié au gré du concepteur par dopage avec un métal tel que par exemple le tungstène ou le tantale ou le titane.

Les transistors à effet de champ connus sous le nom de MIS, c'est-à-dire métal/isolant/semiconducteur, ont montré qu'ils présentent des avantages aussi bien dans le domaine de la logique rapide que dans le domaine des hyperfréquences où on peut obtenir une puissance de sortie plus importante.

Le développement de ce type de transistor sur GaAs, par exemple, se heurte cependant à l'impossibilité d'obtenir un phénomène d'inversion ou d'accumulation de charges à l'interface entre la couche d'isolant et la couche de matériau semiconducteur. Il n'est pas possible, dans les conditions actuelles de la technique, d'obtenir une zone de désertion profonde autrement qu'en mode dynamique.

Ces effets observés sur GaAs sont attribués à la charge électrique des états d'interface, entre la couche isolante et le semiconducteur, qui produit un décalage de la courbe de capacité en fonction de la tension, pour le condensateur formé par la métallisation de grille, la couche isolante, et la couche semiconductrice, après polarisation. Aux basses fréquences, la transconductance gm du transistor diminue considérablement.

Cet état de faits, qui est connu, a amené jusqu'à présent deux types de solutions.

Selon la première solution, l'isolant placé entre la métallisation de grille et la couche active du semiconducteur est remplacé par une couche du matériau semiconducteur rendue semi-isolante par une implantation sous la grille. Cette première solution donne un réseau de caractéristiques sans hystérésis. Elle présente cependant l'inconvénient d'une fuite non limitée en polarisation directe due à l'injection de porteurs dans le matériau semi-isolant qui possède une bande interdite identique à celle de la couche active. De plus, la couche semi-isolante ainsi réalisée est sensible aux traitements thermiques même modérés. Les mêmes problèmes se présentent aussi pour les autres semiconducteurs de types III—V fréquemment utilisés dans les hyperfréquences.

La seconde solution consiste à utiliser un matériau diélectrique présentant une certaine fuite. Le composé qui a été utilisé est un oxyde de titane de type $TiO_x$ riche en titane. Des résultats intéressants ont été obtenus en fonctionnement statique et en petits signaux. Cependant la présence d'oxygène dans la couche diélectrique est néfaste si le transistor est réalisé sur un matériau tel que GaAs car l'oxygène oxyde préférentiellement la couche semiconductrice à l'interface.

Dans le transistor selon l'invention, la couche située entre la métallisation de grille et la couche active est un composé du type nitrure de silicium non stoechiométrique, riche en silicium, répondant à la formule générale $Si_xN_yM_z$: cette couche sert d'isolant de grille vis-à-vis du transistor en fonctionnement, M représente un métal et la couche d'isolant de grille est constituée par un nitrure de silicium pour lequel la condition de base est que:

$$\frac{x}{3} > \frac{y}{4}$$

Cette condition entraînant que le nitrure de silicium riche en silicium, présente une fuite de courant.

L'utilisation du nitrure de silicium a déjà été essayée pour réaliser un MISFET, dans lequel la couche isolante est en $Si_3N_4$. Mais les auteurs, dans un article paru dans "Thin Solid Films", vol. 85, n° 1, octobre 1981, pages 61—69, exposent qu'aux débuts de leurs travaux, la couche déposée était en nitrure de silicium non stoechiométrique, et que le procédé, s'est révélé incapable de fournir des couches hautement résistives, ce qui était leur but. Ils ont donc modifié le procédé pour que les couches soient stoechiométriques, c'est-à-dire $Si_3N_4$. Néanmoins, les performances des MISFET, avec isolant de grille en $Si_3N_4$ sont selon eux toujours inférieures à celles des MISFET's isolés par $SiO_2$.

Par ailleurs, la fabrication et les caractéristiques du nitrure de silicium non stoechiométrique sont déjà connues, et décrites par exemple dans "Journal of the Electrochemical Society", vol. 125, n° 5, mai 1978, pages 819—823.

De façon plus précise, l'invention concerne un transistor à effet de champ selon la revendication 1.

L'invention sera mieux comprise par la description d'un exemple de réalisation de transistor selon l'invention, avec une variante de réalisation, cette description s'appuyant sur les figures jointes en annexe et qui représentent:

figure 1: transistor à effet de champ à structure alignée selon l'invention,

figure 2: transistor à effet de champ à structure auto-alignée selon l'invention,

figure 3: courbe capacité-tension d'un transistor selon l'invention,

figures 4, 5: courbes de caractéristiques de sortie sous condition normale et en impulsion d'un transistor selon l'invention.

L'invention est applicable à tous les matériaux semiconducteurs mais elle sera exposée en s'appuyant sur le cas plus précis du GaAs.

En effet, les MISFET sur GaAs ont des performances très intéressantes aussi bien pour les applications numériques à haut débit, c'est-à-dire en gigabit, que pour les applications de puissance en micro-ondes. Mais il est impossible de réaliser des transistors de type MOS à inversion sur GaAs, parce que les phénomènes d'inversion ou d'accumulation d'électrons à l'interface entre les couches isolant et GaAs ne sont pas possibles, la présence d'états d'interface limitant la modulation de la position des bandes de conduction et de valence par rapport au niveau de Fermi.

En outre, il y a de sérieux problèmes d'instabilité dûs à l'état de charge électrique à l'interface, qui créent un déplacement de la courbe représentative de la capacité formée par la métallisation de grille, l'isolant, et le semiconducteur, et ainsi que dans les caractéristiques de transfert du transistor à effet de champ après polarisation. De même, cette instabilité conduit à une réduction de la transconductance gm du transistor à effet de champ aux basses fréquences. Enfin le fonctionnement en désertion profonde n'est possible que dans le mode dynamique.

L'invention dans son fondement, consiste à créer un courant de fuite contrôlé à travers la fine couche isolante, ce courant de fuite étant suffisamment important pour amener les états de l'interface du matériau semiconducteur GaAs en équilibre électrique avec la métallisation de grille, mais suffisamment faible pour ne pas interférer avec le courant du canal. La fuite de la couche isolante court-circuité la capacité de l'isolant aux basses fréquences. Ceci entraîne que la transconductance et la tension de pincement en courant continu sont celles d'un transistor MESFET c'est-à-dire métal-semiconducteur. Aux hautes fréquences, la capacité de la couche isolante est en série avec la capacité de la couche de charge d'espace, dans la couche active du transistor, faisant décroître la transconductance et croître la tension de pincement. Cependant, la modification de capacité peut être vraiment faible, si la couche diélectrique est fine et de constante diélectrique de valeur élevée.

Une solution pour éviter les instabilités caractéristiques du MISFET consiste à remplacer la couche d'oxyde classique dans les transistors de type MISFET par une couche semi-isolante obtenue à partir du matériau semiconducteur de base. R. Pruniaux et ses collaborateurs dans IEEE transaction on electron devices, volume ED19 N° 5 de Mai 1972 et HM Macksey et ses collaborateurs dans Electronics Letters, volume 12 N° 8 du 15 Avril 1976 décrivent tous deux cette solution de couche semi-isolante obtenue par implantation dans la couche semiconductrice. Cette implantation peut être réalisée à l'aide de protons.

TL. Andrade et N. Braslau ont décrit au 39ème Annual Device Research Conference à Santa Barbara, les 22, 24 juin 1981, un transistor à effet de champ doté d'une couche diélectrique de grille présentant une fuite. Cependant, ces auteurs ont utilisé comme couche diélectrique un oxyde de titane qui présente deux inconvénients. D'une part il n'est pas bon d'avoir une couche d'oxyde à proximité d'une couche de GaAs, ou d'un matériau de la famille III—V plus généralement, parce que l'oxygène oxyde préférentiellement GaAs et que des alliages de la forme TiAs se forment à haute température.

Ensuite et consécutivement aux inconvénients énoncés ci-dessus, il n'est pas possible de réalise une structure auto-alignée avec $TiO_x$ pour les MESFETs à grille réfractaire de type TiW ou TiW/ Si.

Le transistor selon l'invention conserve la notion d'état d'équilibre électrique entre les interfaces situées sur les deux faces de la couche diélectrique tout en évitant les problèmes mentionnés ci-dessus pour $TiO_x$, c'est-à-dire, oxydation des couches superficielles de la zone active GaAs par l'oxygène contenu dans le diélectrique et problèmes de tenue en température interdisant la possibilité de réaliser une structure auto-alignée.

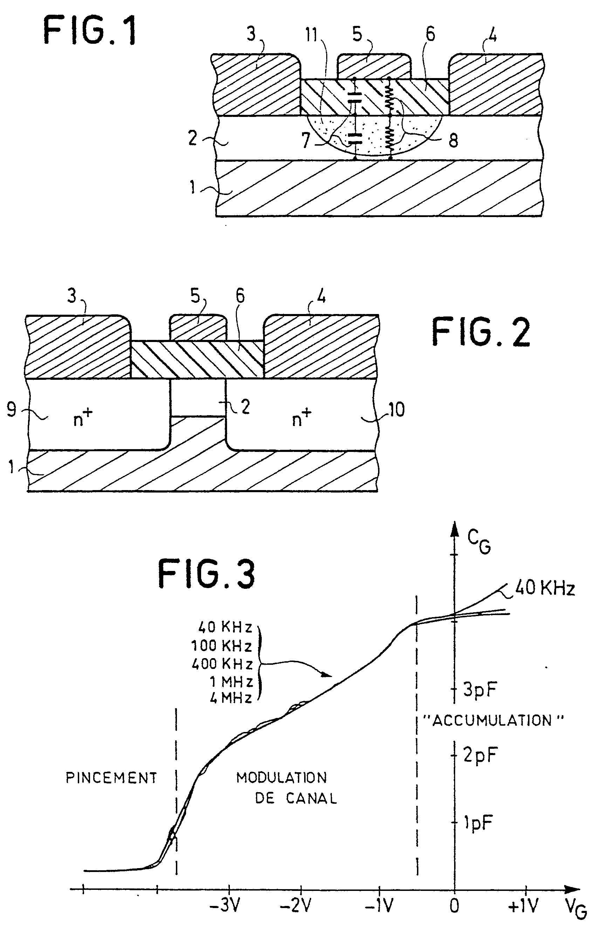

La figure 1 représente de façon très simplifiée la coupe d'un transistor selon l'invention. La géométrie précise du transistor n'est pas le point important: ce qui donne des caractéristiques intéressantes au transistor de l'invention est la nature de la couche semi-isolante placée entre la grille et la couche active du transistor.

Un transistor selon l'invention comporte un substrat 1 en matériau semiconducteur sur lequel est déposé au moins une couche dite couche active 2. La couche active 2 n'est pas détaillée sur le schéma de la figure 1 mais elle peut être composée d'une seule couche épitaxiée ou implantée, ou d'une pluralité de sous-couches de natures différentes, elles-mêmes épitaxiées sur le substrat 1.

Il comporte également une première électrode de source 3 et une seconde électrode de drain 4 entre lesquelles se trouve une éelctrode de commande dite de grille. Selon l'invention la grille 5 est déposée sur une couche 6 qui est un isolant présentant une fuite.

On a représenté en 7 les capacités qui se développent dans les couches déposées sur le substrat et en 8 les résistances de ces mêmes couches. Une première capacité est formée par la métallisation de la grille comme première armature, la couche diélectrique et la surface de la couche active 2 comme seconde armature. Une seconde capacité est la capacité de la zone désertée 11 qui se développe dans la région active. De même, les couches diélectrique 6 et désertée 11 présentent deux résistances de passage 8.

Comme il a été dit, il est connu de réaliser un MISFET comparable à la figure 1 mais dans lequel la couche diélectrique est constituée par un oxyde de titane riche en titane. L'oxyde de titane présente l'inconvénient de contenir de l'oxygène qui oxyde préférentiellement les matériaux de la famille III—V, d'une part, et l'inconvénient d'un alliage à haute température du titane avec ces mêmes composés.

Cependant, avec une telle couche d'oxyde de titane les charges d'interface accumulées sur les interfaces diélectriques—semiconducteurs sont écoulées à travers l'oxyde lègèrement conducteur. Les opérations en hautes fréquences ne sont pas affectées et cette résistance de la couche d'oxyde de titane est shuntée par la capacité grille—couche active.

Selon l'invention, la couche diélectrique 6 est constituée par une couche de nitrure de silicium, riche en silicium, qui peut être dopée avec des métaux lourds de façon à régler le taux de fuite ou la résistance de la couche. Le système silicium-azote a été choisi parce qu'il présente l'avantage de constituer, au cours des opérations de réalisation du transistor, une encapsulation pour le recuit d'implantation, lorsque la zone active est implantée, comme cela est couramment réalisé sur GaAs.

La figure 2 représente une structure de transistor à effet de champ selon l'invention comparable à celle de la figure 1, mais elle met en évidence que la couche active 2 n'est pas comme dans le cas de la figure 1 une couche qui s'étend sur toute la surface du substrat 1 mais qu'elle est au contraire limitée à une région bien définie par des caissons implantés $n^+9$ et 10. Les caissons implantés sont réalisés avant les métallisations de source et de drain, et permettent principalement, de diminuer de façon très importante les résistances série de source et de drain.

Le procédé de fabrication d'un transistor selon l'invention est très légèrement identique à celui d'un transistor conventionnel MESFET c'est-à-dire métal-semiconducteur, ou MISFET c'est-à-dire métal-isolant-semiconducteur.

La couche active peut être réalisée par implantation ionique dans le substrat suivie d'un recuit d'activation à 850°C pendant 20 mn typiquement dans le cas de GaAs.

Si le dispositif comporte des caissons de type $n^+9$ et 10 comme ceux représentés figure 2, ceux-ci sont réalisés par implantation ionique.

Après ces opérations, une couche de nitrure de silicium, riche en silicium, est déposée selon différentes technologies, dépôt chimique en phase vapeur, plasma, pulvérisation. Son épaisseur est 50 nm±10 nm (500 Å±100 Å).

Si la couche de nitrure de silicium comporte un dopage métallique, ce dernier est réalisé par exemple, an cours de la pulvérisation ou par implantation dans la couche déposée, de métaux tels que W, Ta, Ti, la couche semi isolante non stoechiométrique ayant alors une formule brute de type $Si_xN_yM_z$. M étant le métal de dopage.

La non-stoechiométrie de la couche semi-isolante 6 en nitrure de silicium est contrôlée par l'indice de réfraction qui est choisi de l'ordre de 2,7 mais est de façon plus générale compris entre 2,2 et 3.

Après le dépôt de la couche diélectrique 6, la métallisation de grille est opérée puis les ouvertures dans la couche semi-isolante sont réalisées pour pouvoir déposer les contacts ohmiques de source et de drain.

Le processus de réalisation se termine par une étape de métallisation épaisse en vue des interconnexions ultérieures.

L'une des propriétés de la couche de nitrure de silicium est que sa non stoechiométrie lui permet d'avoir une conductivité intermédiaire entre celle du composé stoechiométrique $Si_3N_4$ et celle de la couche active, en restant copendant dans un domaine de résistance de l'ordre du Gigohm: $10^8$—$1$ $cm^{-1}$ par exemple. Sa constante diélectrique est voisine de 9: $\varepsilon \approx 9$.

Sa nature proche du nitrure de silicium stoechiométrique, c'est-à-dire $Si_3N_4$, lui permet de jouer le rôle d'encapsulant pour un recuit d'implantation.

Elle permet d'autre part de réaliser une structure auto-alignée telle que celle représentée figure 2, c'est-à-dire une structure dans laquelle on a réalisé des caissons $n^+$ sous les contacts de source et de drain par implantation, la grille suivant de masque d'implantation. Le recuit d'implantation de ces zones $n^+$ ne pose alors plus de problèmes de maintien en température du système grille/semi-conducteur, problème bien connu pour les transistors MESFET auto-alignés à grille réfractaire.

Le transistor réalisé selon le procédé décrit, et doté d'une couche semi-isolante en nitrure de silicium non stoechiométrique, a des caractéristiques données dans les figures suivantes qui montrent que les courbes de capacité en fonction de la tension sur la grille ne présentent plus d'instabilité, tandis que les caractéristiques de courant de drain en fonction de la tension sur la grille n'ont pas d'hystérésis entre le pincement et le canal ouvert.

La figure 3 donne la caractéristique C—V c'est-à-dire la capacité présentée par le système diélectrique/zone désertée, mesurée entre grille et source. Les mesures sont faites sur un transistor ayant une longueur de grille de 20 microns. Elle représente une courbe de désertion profonde stable, sans dispersion entre 40 KHz et 4 MHz.

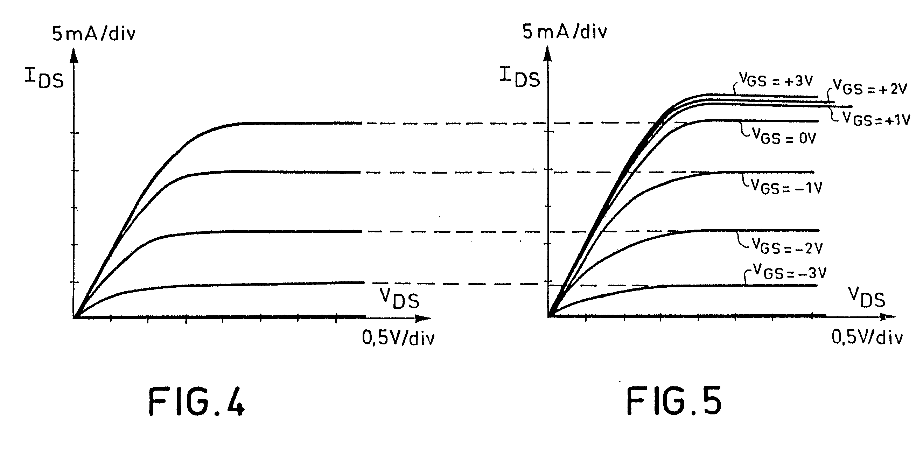

Les figures 4 et 5 donnent les caractéristiques I—V du transistor, c'est-à-dire le courant.de canal $I_{DS}$ fonction de la tension drain/source $V_{DS}$ appliquée pour différentes tensions de grille $V_{GS}$.

Les tensions successivement appliquées à la grille varient de 0 V à −3 V par pas de −1V dans le cas de la figure 4 alors qu'elles varient de +3 à −3V toujours par pas de −1V dans le cas de la figure 3. On remarque que, pour une même tension de grille, la courbe du courant de canal fonction de $V_{DS}$ est identique sur les deux figures. Il n'y a donc pas de charges piégées à l'interface, la fuite obtenue par la nature non stoechiométrique du nitrure se révèle suffisante.

Les courbes, qui représentent les qualités du transistor selon l'invention mettent en évidence des caractéristiques essentiellement stables opposées aux instabilités rencontrées précédemment avec les MISFET.

Une application du transistor selon l'invention est la réalisation de circuits intégrés sur GaAs, entre autres, pour des utilisations en logique rapide et en hyperfréquences.

**Revendications**

1. Transistor à effet de champ, fonctionnant en mode de désertion profonde, comprenant, supportées par un substrat (1), une couche active (2) en matériau semiconducteur, deux électrodes d'accès (3, 4) dites de source et drain, entre lesquelles s'écoule le courant électrique dans la couche active (2), le passage du courant étant contrôlé par une électrode de grille (5) séparée de la couche active (2) par une couche intermédiaire (6) en matériau semi-isolant, ce transistor étant caractérisé en ce que la couche intermédiaire (6) est en nitrure de silicium riche en silicium, et en ce que la résistivité de la couche intermédiaire, semi-isolante (6), est en outre contrôlée par dopage par des ions métalliques, au niveau de quelques parties par million, par implantation ou pulvérisation cathodique, la formule de la couche intermédiaire (6) non stoechiométrique, étant $Si_x N_y M_z$, M étant un métal, et les properties non stoechiométriques étant telles que $x/3 > y/4$.

2. Transistor à effet de champ selon la revendication 1, caractérisé en ce que l'indice de réfraction n, mesuré à la longueur d'onde 600 nm (6000 Å) étant une mesure de la non-stoechiométrie de la couche semi-isolante (6), celle-ci à un indice de réfraction $2,2 < n < 3$.

3. Transistor à effet de champ selon la revendication 1, caractérisé en ce que la couche semi-isolante (6) a une constante diélectrique $\varepsilon \approx 9$.

4. Transistor à effet de champ selon la revendication 1 caractérisé en ce que la couche semi-isolante (6), qui s'étend à la surface de la couche active (2) entre les deux électrodes d'accès (3, 4) a une épaisseur 50 nm±10 nm (500 Å±100 Å).

5. Transistor à effet de champ selon la revendication 1, caractérisé en ce que le métal est choisi parmi: le tungstène W, tantale Ta, titane Ti.

6. Transistor à effet de champ selon la revendication 1, caractérisé en ce que la résistivé de la couche semi-isolante (6) est adaptée pour permettre l'équilibre des charges d'interfaces dans le condensateur formé par la métallisation de grille (5), la couche semi-isolante (6) et la couche active conductrice (2), sans influer sur le courant du canal entre source et drain (3, 4).

7. Transistor à effet de champ selon la revendication 1, caractérisé en ce que la résistivité de la couche semi-isolante est voisine de $10^8$ Ω cm$^{-1}$

8. Transistor à effet de champ selon la revendication 1, caractérisé en ce que le matériau semi-conducteur de la couche active (2) est un matériau de la famille III—V, tel que GaAs.

**Patentansprüche**

1. Feldeffekttransistor, der mit tiefreichender Verarmung arbeitet und von einem Substrat (1) getragen aufweist: eine aktive Schicht (2) aus Halbleitermaterial, zwei Zugangselektroden (3, 4), die als Source und Drain bezeichnet werden und zwischen denen der elektrische Strom in der aktiven Schicht (2) fließt, wobei der Stromdurchgang durch eine Gateelektrode (5) gesteuert wird, die von der aktiven Schicht (2) durch eine Zwischenschicht (6) aus halbisolierendem Material getrennt ist, wobei dieser Transistor dadurch gekennzeichnet ist, daß die Zwischenschicht (6) aus Siliciumnitrid ist, das an Silicium reich ist, und daß der spezifische Widerstand der halbisolierenden Zwischenschicht (6) ferner durch Dotierung mit metallischen Ionen in Höhe von einigen Teilen pro Million durch Implantation oder Kathodenzerstäubung gesteuert ist, wobei die nicht stöchiometrische Formel der Zwischenschicht (6) $Si_x N_y M_z$ ist, worin M ein Metall ist und wobei die nicht stöchiometrischen Proportionen so sind, daß $x/3 > y/4$.

2. Feldeffekttransistor nach Anspruch 1, dadurch gekennzeichnet, daß der Brechungsindex n, gemessen bei der Wellenlänge 600 nm (6000Å) ein Maß für die Nichtstöchiometrie der halbisolierenden Schicht (6) ist, wobei letztere einen Brechungsindex $2,2 < n < 3$ aufweist.

3. Feldeffekttransistor nach Anspruch 1, dadurch gekennzeichnet, daß die halbisolierende Schicht (6) eine Dielektrizitätskonstante $\varepsilon \cong 9$ aufweist.

4. Feldeffekttransistor nach Anspruch 1, dadurch gekennzeichnet, daß die halbisolierende Schicht (6), die sich an der Oberlfäche der aktiven Schicht (2) zwischen den zwei Zugangselektroden (3, 4) erstreckt, eine Dicke von 50 nm±10 nm (500Å±100Å) aufweist.

5. Feldeffekttransistor nach Anspruch 1, dadurch gekennzeichnet, daß das Metall ausgewählt ist unter: Wolfram W, Tantal Ta, Titan Ti.

6. Feldeffekttransistor nach Anspruch 1, dadurch gekennzeichnet, daß der spezifische Widerstand der halbisolierenden Schicht (6) angepaßt ist, um das Gleichgewicht der Grenzschichtladungen in dem Kondensator zu ermöglichen, der durch die Gatemetallisierung (5), die halbisolierende Schicht (6) und die leitende aktive Schicht (2) gebildet ist, ohne einen Einfluß auf den Kanalstrom zwischen Source und Drain (3, 4) zu haben.

7. Feldeffekttransistor nach Anspruch 1, dadurch gekennzeichnet, daß der spezifische Widerstand der halbisolierenden Schicht in der Nähe von $10^8$Ωcm$^{-1}$ liegt.

8. Feldeffekttransistor nach Anspruch 1, dadurch gekennzeichnet, daß das Halbleitermaterial der aktiven Schicht (2) ein Material der Famillie III—V wie GaAs ist.

**Claims**

1. A field effect transistor operating in a deep depletion mode and comprising, supported on a substrate (1), an active layer (2) of semiconductor material, two access electrodes (3 and 4) termed source and drain, between which the electric current flows in the active layer (2), the passage of the current being controlled by a gate electrode (5) separated from the active layer (2) by an intermediate layer (6) of semi-insulating material, said transistor being characterized in that the intermediate layer (6) is made of silicon nitride rich in silicon and in that the resistivity of the intermediate semi-insulating layer (6) is furthermore controlled by doping with metallic ions, at a level of a few parts per million, by implantation or by cathodic sputtering, the formula of the non-stoichiometric intermediate layer (6) being $Si_xN_yM_z$, wherein M is a metal and the non-stoichiometric proportions are such that $x/3 > y/4$.

2. The field effect transistor as claimed in claim 1 characterized in that the index of refraction n measured at a wavelength of 600 nm (6000 Å), this being a measure of the non-stoichiometry of the semi-insulating layer (6), the latter has an index of refraction of $2.2 < n < 3$.

3. The field effect transistor as claimed in claim 1 characterized in that the semi-insulating layer (6) has a dielectric constant $\varepsilon \approx 9$.

4. The field effect transistor as claimed in claim 1 characterized in that the semi-insulating layer (6) which extends over the surface of the active layer (2) between the two access electrodes (3 and 4), has a thickness of $50 \pm 10$ nm ($500\text{Å} \pm 100\text{Å}$).

5. The field effect transistor as claimed in claim 1 characterized in that the metal is selected from the group comprising tungsten W, tantalum Ta and titanium Ti.

6. The field effect transistor as claimed in claim 1 characterized in that the resistivity of the semi-insulating layer (6) is adapted to permit the establishment of an equilibrium of the interface charges in the capacitor formed by the metallized layer of the gate (5), the semi-insulating layer (6) and the conducting active layer (2) without influencing the channel current between the source and the drain (3 and 4).

7. The field effect transistor as claimed in claim 1 characterized in that the resistivity of the semi-insulating layer is of the order of $10^8 \Omega \text{cm}^{-1}$.

8. The field effect transistor as claimed in claim 1 characterized in that the semiconductor material of the active layer (2) is a material of the III—VI group such as GaAs.

0 128 061

FIG.1

FIG.2

FIG.3

1

FIG.4

FIG.5